# EUROPEAN PATENT APPLICATION

(11) **EP 3 444 854 A2**
(43) Date of publication of application: **20.02.2019**
(21) Application number: 18188702.7
(22) Date of filing: 13.08.2018
(51) Int. Cl.: H01L 31/18

(54) **METHOD AND SYSTEM FOR DRYING PASTE FOR SOLAR CELL**

(30) Priority: 16.08.2017 CN 201710701674
(71) Applicant: Beijing Juntai Innovation Technology Co., Ltd, 100176 Beijing (CN)
(72) Inventor: Zheng, GUO, Beijing, 100176 (CN); Tongyang, HUANG, Beijing, 100176 (CN); Xudong, WANG, Beijing, 100176 (CN); Cen, CAI, Beijing, 100176 (CN); Chenhui, YUE, Beijing, 100176 (CN)
(74) Representative: Nony

(57) **Abstract**

A method and system for drying paste for a solar cell are disclosed. The method includes the following steps: delivering a solar cell to a position below a laser; detecting position information of the solar cell; and starting the laser to emit a laser beam for drying the solar cell according to the position information.

## Description

### TECHNICAL FIELD

The present disclosure relates to methods for manufacturing solar cells, and for example, relates to a method and system for drying paste for a solar cell.

### BACKGROUND

Photovoltaic power generation is a clean energy source and is rapidly developed in recent years. With respect to a heterojunction solar cell, of the formation of an electrode is an indispensable procedure.

In a solar cell manufacturing process of a related technology, the formation of the electrode is as follow. A desired electrode pattern is formed of conductive paste by means of a screen printing method, and then the electrode pattern is subjected to hot air or infrared drying and sintering.

In the related technology, a drying furnace and a sintering furnace are positioned on a metal rail through a monolithic or clamping manner. Such furnaces have large volume, low thermal absorption efficiency, high cost, large power loss and high maintenance cost.

### SUMMARY

The present disclosure provides a method and system for drying paste for a solar cell, so as to solve problems in a relevant technology, increase production efficiency and reduce power cost.

A method of drying paste for a solar cell includes the following steps:
delivering the solar cell to a position below a laser;
detecting position information of the solar cell; and
starting the laser to emit a laser beam for drying the solar cell according to the position information of the solar cell.

In an exemplary embodiment, after starting the laser to emit a laser beam for drying the solar r cell according to the position information of the solar cell, the method further includes:
outputting the solar cell and causing the laser to stop emitting the laser beam; and
waiting till a next solar cell is delivered to the position below the laser.

In an exemplary embodiment, in the above method, a step of delivering a solar cell to a position below a laser includes: delivering the solar cell to the position below the laser by using a conveyor belt.

In an exemplary embodiment, in the above method, a step of detecting position information of the solar cell includes: detecting the position information of the solar cell by a sensor.

In an exemplary embodiment, the method further includes: discharging, by an exhaust system, matters generated when drying the solar cell.

In an exemplary embodiment, in the above method, the outputting the solar cell and causing the laser to stop emitting the laser beam includes: stopping exhaust operation of the exhaust system at the time of causing the laser to stop emitting the laser beam. A step of waiting till a next solar cell is delivered to the position below the laser comprises: starting the exhaust system when the next solar cell is delivered to the position below the laser.

In an exemplary embodiment, in the above method, a step of the discharging by an exhaust system matters generated when drying the solar cell includes: controlling the exhaust system to operate without interruption and discharging the matters generated when drying the solar cell by the exhaust system.

A system for drying paste for a solar cell includes a laser and a master controller. The laser is configured to dry the solar cell, and the master controller is configured to cause the laser to emit a laser beam for drying the solar cell according to the position information of the solar cell.

In an exemplary embodiment, the above system further includes a conveyor belt and a sensor. The conveyor belt is configured to deliver the solar cell to the positon below the laser and is further configured to output the solar cell. The sensor is configured to detect the position information of the solar cell. The master controller is further configured to cause the laser to stop emitting the laser beam when the solar cell is outputted.

In an exemplary embodiment, the above system further includes an exhaust system configured to discharge matters generated when drying the solar cell.

The master controller is further configured to stop exhaust operation of the exhaust system at the time of causing the laser to stop emitting the laser beam, and to start the exhaust system when the next solar cell is delivered to the positon below the laser. Alternatively, the master controller is further configured to control the exhaust system to operate without interruption.

In the method and system for drying paste for the solar cell provided by the present disclosure, the laser is controlled to emit the laser beam to dry the solar cell, so a furnace body for drying of a linear laser can be made to be very small. Compared with a relevant technology, the present disclosure saves an occupation area and increases a utilization ratio of a factory building.

### BRIEF DESCRIPTION OF DRAWINGS

FIG. 1 is a diagram illustrating the working principle of a system for drying paste for a solar cell provided by an embodiment;
FIG. 2 is a diagram illustrating a simplified structure of a system for drying paste for a solar cell provided by an embodiment;
FIG. 3 is a flow chart illustrating a method for drying paste for a solar cell provided by an embodiment; and

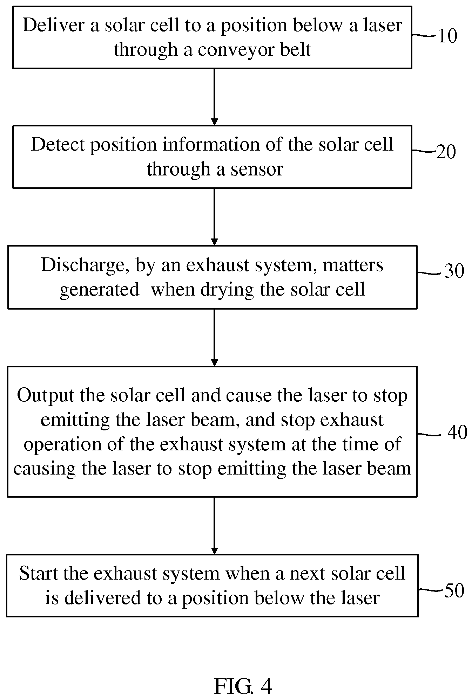

FIG. 4 is a flow chart illustrating a method for drying paste for a solar cell provided by another embodiment.

### List of reference numerals:

1-laser; 11-output head; 12-laser beam; 2-master controller; 3-solar cell; 4-gap; 5-conveyor belt; 6-sensor; and 7-exhaust system

### DETAILED DESCRIPTION

Embodiments of the present disclosure are described below. Examples of described embodiments are shown in drawings. Same or similar numerals represent same or similar elements throughout or elements with same or similar functions. Embodiments described below by referring to drawings are exemplary and are merely for explaining the present disclosure, but do not limit the present disclosure.

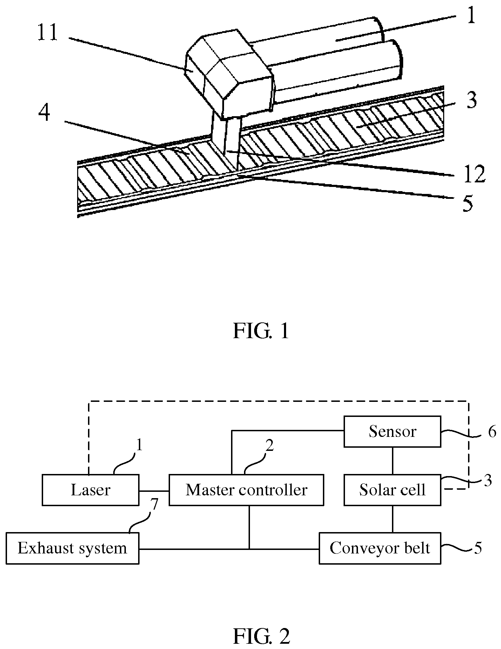

Embodiments of the present disclosure provide a method for drying paste for a solar cell. The drying method is suitable to a system for drying paste for a solar cell. FIG. 1 is a diagram illustrating the working principle of the system for drying paste for a solar cell provided by the present embodiment. FIG. 2 is a diagram illustrating a simplified structure of the system for drying paste for a solar cell provided by the present embodiment. By referring to FIG. 1 and FIG. 2, the system includes a laser 1 and a master controller 2. The laser 1 is configured to dry a solar cell 3, and the master controller 2 is configured to start the laser 1 to emit a laser beam 12 according to the position information of the solar cell 3 so as to dry the solar cell 3.

In an exemplary embodiment, the system further includes a conveyor belt 5 and a sensor 6. The conveyor belt 5 is configured to deliver the solar cell 3 to a position below the laser 1 and is also configured to output the solar cell 3. The sensor 6 is configured to detect the position information of the solar cell 3. The master controller 2 is also configured to cause the laser 1 to stop emitting the laser beam 12 when the solar cell 3 is outputted.

When the solar cells 3 are positioned on the conveyor belt 5, a gap 4 exists between two adjacent solar cells. The minimal value of the gap 4 should be set to at least ensure that, after the previous one of the two adjacent solar cells is dried by the laser 1, there is enough time for the laser 1 to be be started so as to dry the next solar cell.

In an exemplary embodiment, the system further includes a drying furnace body, and the laser is arranged in the drying furnace body.

The solar cell 3 that has been subjected to screen printing is delivered to the drying furnace body from a working position for the screen printing, and the solar cell 3 is delivered forwards by the conveyor belt 5. When the solar cell 3 is delivered to the position below the laser 1, the sensor 6 detects the solar cell 3 and an output head 11 of the laser 1 starts to output the laser beam 12. One, or two or more lasers 1 may be arranged. The output head 11 of the laser 1 outputs the laser beam 12 with a width of about 160 mm. The solar cell 3 is scanned by the laser beam, such that the solar cell 3 is dried. The solar cell 3 passes through the uniform beam at constant speed, such that the solar cell 3 is dried. Linear laser has characteristics of uniform light intensity distribution, controllable laser power and high processing speed. When the solar cell 3 moves out of the detection range of the sensor, the drying process of the solar cell 3 is finished, and the laser 1 is stopped to enter a standby state and waits for a next solar cell. The above action is repeated until all the solar cells are dried.

The system for drying the paste for the solar cell provided by the present embodiment dries the solar cell 3 by controlling the laser 1 to emit the laser beam 12. The housing of the linear laser 1 can be made to be very small. With the system for drying the paste, an occupation area is reduced and a utilization ratio of a factory building is increased compared with the related technology. In addition, since the laser beam 12 is focused in a certain region for the drying process and the housing is small, spreading of organisms and other harmful gas is reduced and the dried organisms or other harmful gas can be discharged together in a better and more efficient manner. Thus, a drying effect is better and secondary pollution is reduced. Conversion efficiency of the solar cell can also be obviously increased. In the drying process, the paste directly absorbs laser irradiation and reduces the thermal loss to an ambient environment to a minimal value, thereby increasing the system's electrothermal utilization ratio and reducing power energy consumption by half (compared with the traditional drying furnace and the sintering furnace).

In an exemplary embodiment, the system further includes an exhaust system 7 configured to discharge the matter generated in the process of drying the solar cell 3. The master controller 2 is further configured to stop exhaust operation of the exhaust system 7 upon stropping the laser 1 from emitting the laser beam 12, and to start the exhaust system 7 when the next solar cell is delivered to a position for drying. Alternatively, the master controller 2 is further configured to control the exhaust system 7 to work continuously. Namely, the exhaust system 7 can be individually controlled, and can be in an operating state all the time, or the exhaust system 7 operates along with the operation of the laser 1.

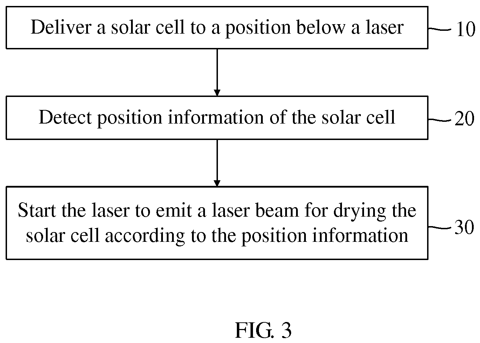

FIG. 3 is a flow chart illustrating a method for drying paste for a solar cell provided by the present embodiment. As shown in FIG. 3, embodiments of the present disclosure further provide a method for drying paste for a solar cell, and the method includes the following steps.

In step 10, a solar cell 3 is delivered to a position below the laser 1. Optionally, the current solar cell 3 may be delivered through a conveyor belt 5.

In step 20, position information of the solar cell 3 is detected. In the step, the position information of the solar cell 3 may be detected through a sensor 6.

In step 30, the laser 1 is started to emit a laser beam 12 according to the position information to dry the solar cell 3.

In the process of drying the solar cell 3, matters generated in the process of drying the solar cell can be discharged by an exhaust system 7. The exhaust system 7 can discharge organisms and volatile matter produced in the process of drying to an exhaust duct.

In an exemplary embodiment, after the step 30, the method further includes the following steps.

In step 40, the solar cell 3 is outputted and the laser 1 stops emitting the laser beam 12. When the solar cell moves out of the detection range of the sensor 6, the master controller 2 sends a control signal to cause the laser 1 to stop emitting the laser beam 12.

In step 50, the laser 1 is not started until the next solar cell is delivered to the position for drying.

The above step 10 to step 50 are repeated.

In an exemplary embodiment, the exhaust system 7 may operate all the time, or may operate along with the operation of the laser 1.

When the exhaust system 7 is configured to operate all the time, the step 30 may be as follows: the exhaust system 7 is controlled to operate without interruption, and the matter produced in the process of drying the solar cell 3 is discharged by the exhaust system 7.

When the exhaust system 7 is configured to operate along with the operation of the laser 1, the step 40 also includes: exhaust operation of the exhaust system 7 is stopped when the laser 1 stops emitting the laser beam 12., and the step 50 also includes: the exhaust system 7 is started when the next solar cell is delivered to the position for drying.

## Claims

1. A method for drying paste for a solar cell, comprising:
delivering (10) the solar cell to a position below a laser;
detecting (20) position information of the solar cell; and
starting (30) the laser to emit a laser beam for drying the solar cell according to the position information of the solar cell.

2. The method according to claim 1, after starting the laser to emit a laser beam for drying the solar r cell according to the position information of the solar cell, further comprising:
outputting the solar cell and causing the laser to stop emitting the laser beam; and
waiting till a next solar cell is delivered to the position below the laser.

3. The method according to claim 1 or claim 2, wherein the delivering a solar cell to a position below a laser comprises: delivering the solar cell to the position below the laser by using a conveyor belt.

4. The method according to claim 1 or claim 2, wherein the detecting position information of the solar cell comprises: detecting the position information of the solar cell by a sensor.

5. The method according to claim 2, further comprising: discharging, by an exhaust system, matters generated when drying the solar cell.

6. The method according to claim 5, wherein the outputting the solar cell and causing the laser to stop emitting the laser beam comprises: stopping exhaust operation of the exhaust system at the time of causing the laser to stop emitting the laser beam; and
the waiting till a next solar cell is delivered to the position below the laser comprises: starting the exhaust system when the next solar cell is delivered to the position below the laser.

7. The method according to claim 5, wherein the discharging by an exhaust system matters generated when drying the solar cell comprises:
controlling the exhaust system to operate without interruption and discharging the matters generated when drying the solar cell by the exhaust system.

8. A system for drying paste for a solar cell, comprising: a laser (1) and a master controller (2),
wherein the laser is configured to dry a solar cell (3) at a position below the laser (1); and the master controller (2) is configured to cause the laser (1) to emit a laser beam (12) for drying the solar cell (3) according to the position information of the solar cell (3).

9. The system according to claim 8, further comprising a conveyor belt (5) and a sensor (6),
wherein the conveyor belt (5) is configured to deliver the solar cell (3) to the positon below the laser (1) and is further configured to output the solar cell (3);
the sensor (6) is configured to detect the position information of the solar cell (3); and
the master controller (2) is further configured to cause the laser (1) to stop emitting the laser beam when the solar cell (3) is outputted.

10. The system according to claim 9, further comprising an exhaust system (7) configured to discharge matters generated when drying the solar cell (3);
wherein the master controller (2) is further configured to stop exhaust operation of the exhaust system (7) at the time of causing the laser to stop emitting the laser beam, and to start the exhaust system (7) when the next solar cell is delivered to the positon below the laser.

11. The system according to claim 9, further comprising an exhaust system (7) configured to discharge matters generated when drying the solar cell (3);
wherein the master controller (2) is further configured to control the exhaust system (7) to operate without interruption.
